# EUROPÄISCHE PATENTSCHRIFT

(11) **EP 3 411 803 B1**
(45) Veröffentlichungstag und Bekanntmachung des Hinweises auf die Patenterteilung: **12.07.2023**
(21) Anmeldenummer: 17715073.7
(22) Anmeldetag: 28.03.2017
(51) Int. Cl.: G06F 40/143, G06F 40/146, H03M 7/30

(54) **GERÄT UND VERFAHREN ZUR BEARBEITUNG EINES BINÄRKODIERTEN STRUKTURDOKUMENTS**
DEVICE AND METHOD FOR PROCESSING A BINARY-CODED STRUCTURE DOCUMENT
APPAREIL ET PROCÉDÉ DE TRAITEMENT D'UN DOCUMENT DE STRUCTURE À CODAGE BINAIRE

(30) Priorität: 12.04.2016 DE 102016206046
(43) Veröffentlichungstag der Anmeldung: 12.12.2018
(73) Patentinhaber: Siemens Aktiengesellschaft, 80333 München (DE)
(72) Erfinder: KUNTSCHKE, Richard, 84144 Geisenhausen (DE); PEINTNER, Daniel, 39037 Meransen Mühlbach (IT); SCHOLZ, Andreas, 85716 Unterschleißheim (DE)
(74) Vertreter: Siemens Patent Attorneys
(86) Internationale Anmeldenummer: PCT/EP2017/057237
(87) Internationale Veröffentlichungsnummer: WO 2017/178222

(56) Entgegenhaltungen:
- EP-A2- 2 690 564
- US-B2- 8 914 718
- YUSUKE DOI ET AL: "XML-less EXI with code generation for integration of embedded devices in web based systems", INTERNET OF THINGS (IOT), 2012 3RD INTERNATIONAL CONFERENCE ON THE, IEEE, 24. Oktober 2012 (2012-10-24), Seiten 76-83, XP032297313, DOI: 10.1109/IOT.2012.6402307 ISBN: 978-1-4673-1347-6

## Beschreibung

Die Erfindung betrifft ein Gerät sowie ein Verfahren zur Bearbeitung eines binärkodierten Strukturdokuments.

Im Stand der Technik sind textbasierte Beschreibungssprachen zur Spezifikation von Datenformaten und der für eine Bearbeitung der Daten benötigten Verfahren bekannt. Ein Strukturdokument im Sinne dieser Beschreibung umfasst zumindest teilweise Passagen in einer Beschreibungssprache.

Eine bekannte Beschreibungssprache ist »Extensible Markup Language«, abgekürzt XML, mit welcher hierarchisch strukturierte Daten in Textform bzw. »Plain Text« beschrieben werden. Die Beschreibungssprache XML wird für einen plattformunabhängigen Austausch von Daten zwischen Rechnersystemen eingesetzt. Aufgrund der textuellen Natur von XML ist diese sowohl durch Maschinen als auch durch Menschen lesbar.

In der Beschreibungssprache XML vorliegende Strukturdokumente werden zur Bearbeitung - hierzu zählen insbesondere durchsuchen, filtern, manipulieren, transformieren und abfragen von Daten - der darin enthaltenen Daten üblicherweise in eine Speicherrepräsentation überführt, welche in der Fachwelt auch als »in-memory«-Modell bekannt ist. Eine bekannte Spezifikation für den Zugriff auf eine Speicherrepräsentation von XML-Dokumenten ist das »Document Object Model« bzw. DOM, welche eine Objektschnittstelle für einen Datenzugriff durch einen oder mehrere Bearbeitungsprozesse zur Verfügung stellt. Die Objektschnittstelle ist beispielsweise als Programmierschnittstelle bzw. API (Application Programming Interface) ausgeführt. Die Speicherrepräsentation ist allerdings um ein Vielfaches größer als das zugehörige Strukturdokument. Aus diesem Grund ist eine Bearbeitung umfangreicherer Strukturdokumente in ressourcenlimitierten - d.h. über begrenzten Speicherplatz und/oder Rechenleistung verfügenden - Geräten oftmals nicht oder nur mit Einschränkungen möglich. Zu solchen ressourcenlimitierten Geräten zählen beispielsweise eingebettete Systeme bzw. »Embedded Systems« für Überwachungs-, Steuerungs- oder Regelfunktionen z.B. in Form sogenannter intelligenter Sensoren, insbesondere in einer Fertigungslinie oder in einem Fahrzeug.

Häufig ist ein schneller Datenaustausch zwischen Geräten erforderlich, welcher mit einer textuellen Beschreibungssprache wie XML nur unzureichend möglich ist. Daher wurden binäre Repräsentationen von XML für einen effizienten Datenaustausch vorgeschlagen. Eine als »Efficient XML Interchange«, abgekürzt EXI, bezeichnete Binärrepräsentation von XML benötigt im Vergleich zu textbasierten XML-Daten weniger Übertragungsbandbreite beim Datenaustausch zwischen Geräten bzw. Rechnersystemen allgemeiner Art.

Das Austauschformat EXI entfaltet seine Vorteile nicht nur im namensgebenden Datenaustausch zwischen Rechnersystemen, sondern auch bei einer gerätinternen Bearbeitung eines binärkodierten Strukturdokuments in ressourcenlimitierten Geräten. Eine geräteinterne Bearbeitung des binärkodierten Strukturdokuments, also im EXI-Format, erweist sich oftmals als effizienter gegenüber der Verwendung des XML-Formats, zumal die Daten zwischen Geräten ohnehin gemäß EXI-Spezifikationen ausgetauscht werden.

Für eine geräteinterne Bearbeitung wird das binärkodierte Strukturdokument sodann - in analoger Weise zu dem diesem binärkodierten Strukturdokument zugrundeliegenden, in einer textbasierten Beschreibungssprache aufgebauten Strukturdokument - in eine Speicherrepräsentation überführt, um einem oder mehreren Bearbeitungsprozessen über eine Objektschnittstelle Zugriff auf die Daten des binärkodierten Strukturdokuments zu ermöglichen. Auch eine gerätinterne Bearbeitung des binärkodierten Strukturdokuments stößt in ressourcenlimitierten Geräten auf Grenzen, welche Überlegungen zur Größe der Speicherrepräsentation in Abwägung zu einer begrenzten Speicherkapazität eines Arbeitsspeichers des Geräts erforderlich machen.

Überschreitet die Speicherrepräsentation eines Strukturdokuments eine vorbestimmte Größe, muss das zugehörige Strukturdokument unter Verzicht auf ursprünglich eingeplante Funktionalitäten auf eine zulässige Größe beschnitten werden. Scheidet diese Möglichkeit aus, müssen unweigerlich proprietäre Lösungen für eine schlankere Speicherrepräsentation oder alternative Bearbeitungsprozesse ergriffen werden, welche für einen jeweiligen Anwendungsfall individuell zu gestalten sind. Das bedeutet zwangsläufig, dass für neue oder geänderte Anwendungsfälle wiederum eine Alternativlösung erarbeitet werden muss. Dies ist für das grundsätzliche Ziel einer generisch einsetzbaren Lösung nicht vorteilhaft.

Es hat sich weiterhin gezeigt, dass in den möglichen Bearbeitungsoperationen vor allem Leseoperationen gegenüber Operationen mit Schreibzugriff überwiegen. Im Unterschied zu Leseoperationen werden in allgemeinen Bearbeitungsoperationen Daten nicht nur ausgelesen, sondern auch verändert, eingeschrieben oder neu strukturiert. In diesen Leseoperationen wiederum überwiegen strukturelle Leseoperationen an einem binärkodierten Strukturdokument gegenüber Leseoperationen, in denen ein Inhalt ausgelesen werden soll. Zu erstgenannten strukturellen Leseoperationen zählen insbesondere Anfragen an einen Hierarchiezusammenhang, an eine Anzahl oder an bestimmte Kategorien von zu bestimmenden Elementen innerhalb der Struktur des zugrundeliegenden Strukturdokuments. Diese strukturellen Leseoperationen gebieten üblicherweise eine Bearbeitung der kompletten Speicherrepräsentation eines Strukturdokuments, welche in der Speicherrepräsentation z.B. in einer Baumstruktur repräsentiert wird. Im Folgenden wird aus Gründen der Allgemeingültigkeit auf alle genannten lesenden und schreibenden Operationen mit dem allgemeinen Begriff Bearbeitungsoperationen Bezug genommen.

Das Dokument EP 2 690 564 A2 beschreibt Systeme und Verfahren zum Zwischenspeichern von XML-Informationssätzen mit verzögerter Knoteninstanziierung. Hierbei werden große XML-Dokumente analysiert, geparste Daten und einige zugehörige Metadaten in mehreren unabhängigen Blöcken oder Partitionen gespeichert und nur das von einem Programm angeforderte Objektmodell wird instantiiert. Durch die Einführung von logischen Verweisen anstelle von physikalischen Speicheradressen in solchen vorgeparsten Partitionen wird es ermöglicht, die Partitionen durch eine Caching-Speicherhierarchie zu verschieben, ohne notwendigerweise Speicherreferenzen anzupassen oder zu codieren, wodurch eine dynamische Nutzung der erzeugten Partitionen ermöglicht wird.

Das Dokument US 8,914,718 B2 behandelt das Speichern, Bearbeiten und Kodieren von strukturierten Dokumenten wie zum Beispiel XML-Dokumenten.

Die vorliegende Erfindung ist vor die Aufgabe gestellt, ein Verfahren in einem Gerät zu schaffen, durch welche Bearbeitungsoperationen an einer Speicherrepräsentation eines binärkodierten Strukturdokuments ermöglicht werden, ohne dass die Größe des binärkodierten Strukturdokuments an Grenzen des Geräts stößt.

Die Aufgabe wird durch ein Verfahren mit den Merkmalen des Patentanspruchs 1 gelöst.

Die Erfindung ist von der zentralen Überlegung getragen, ein binärkodiertes Indexdokument zu schaffen, dessen Struktur mit der Struktur des zu bearbeitenden binärkodierten Strukturdokuments identisch ist, im Unterschied zum vollständigen binärkodierten Strukturdokument jedoch nicht alle Inhalte enthält, also beispielsweise keine Attribute, keine Wertzuweisungen von Attributen und keinen Inhalt von Elementen.

Beiden, dem binärkodierten Strukturdokument und dem binärkodierten Indexdokument, liegt ein identisches Strukturdokument zugrunde, welches in einer textbasierten Beschreibungssprache aufgebaut ist, vorzugsweise in XML. Während dem binärkodierten Strukturdokument der volle Inhalt des Strukturdokuments zugrunde liegt, liegt dem binärkodierten Indexdokument lediglich ein struktureller Teilumfang des Strukturdokuments zugrunde. Das Indexdokument enthält sozusagen eine Binärrepräsentation der knappen hierarchischen Datenstruktur der in einer Baumstruktur definierten Elemente, ohne die zugehörigen Inhalte. Aufgrund dieses lediglich strukturellen Teilumfangs benötigt das binärkodierte Indexdokument naturgemäß einen wesentlich geringen Umfang an Speicherplatz als das binärkodierte Strukturdokument.

Das erfindungsgemäße Verfahren sieht nun vor, dass eine Speicherrepräsentation des binärkodierten Indexdokuments in einem Arbeitsspeicher des Geräts hinterlegt wird, während das binärkodierte Strukturdokument in einem dem Gerät zugeordneten Hintergrundspeicher gespeichert wird.

Erfindungsgemäß erfolgt eine Durchführung von Bearbeitungsoperationen durch mindestens einen Bearbeitungsprozess mit Zugriff auf das binärkodierte Indexdokument über eine Objektschnittstelle, wobei bedarfsweise Fragmente des binärkodierten Strukturdokuments seitens der Objektschnittstelle in den Arbeitsspeicher geladen werden.

Die Aufgabe wird weiterhin durch ein Computerprogrammprodukt zur Abarbeitung des erfindungsgemäßen Verfahrens gelöst. Das Computerprogramm wird in einem Prozessor oder Controller abgearbeitet, welcher mit der Abarbeitung das Verfahren ausführt.

Die Aufgabe wird weiterhin durch ein Gerät zur Bearbeitung eines binärkodierten Strukturdokuments gelöst.

Weitere Ausgestaltungen der Erfindung sind Gegenstand der abhängigen Patentansprüche.

Im Folgenden werden weitere Ausführungsbeispiele und Vorteile der Erfindung anhand der Zeichnung näher erläutert. Dabei zeigen:
- Fig. 1:: eine schematische Strukturdarstellung einer Bearbeitung eines binärkodierten Strukturdokuments in einem Gerät; und;
- Fig. 2:: eine schematische Darstellung einer Struktur eines Indexdokuments in Vergleich mit einem zugrundeliegenden in einer textbasierten Beschreibungssprache aufgebauten Strukturdokument.

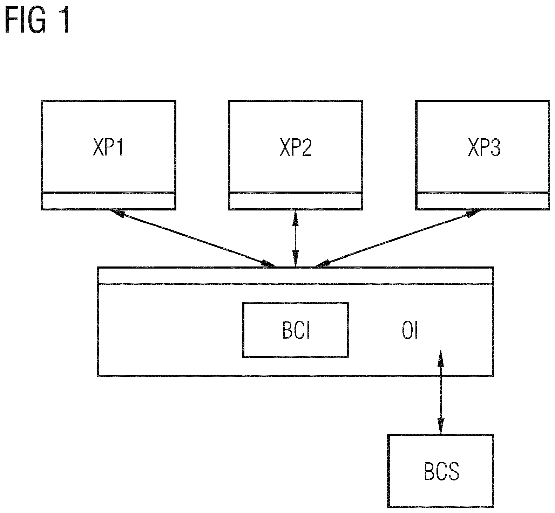

Fig.1 zeigt in nicht abschließender Weise eine schematische Strukturdarstellung einer Bearbeitung eines binärkodierten Strukturdokuments BCS in einem Gerät.

In einer Objektschnittstelle OI ist eine Speicherrepräsentation eines binärkodierten Indexdokuments BCI hinterlegt. Die Objektschnittstelle OI ermöglicht einem jeweiligen Bearbeitungsprozess XP1,XP2,XP3 Zugriff auf die Speicherrepräsentation des binärkodierten Indexdokuments BCI. Die Speicherrepräsentation eines binärkodierten Indexdokuments BCI sowie die Objektschnittstelle OI ist einem - nicht dargestellten - Arbeitsspeicher des Geräts zugeordnet.

In einem - nicht dargestellten - Hintergrundspeicher des Geräts ist ein binärkodiertes Strukturdokument BCS hinterlegt. Eine Speicherrepräsentation dieses binärkodierten Strukturdokuments BCS wird bei Bedarf in die Objektschnittstelle OI geladen.

Die Bearbeitungsprozesse XP1,XP2,XP3 führen eine Bearbeitungsoperation an binärkodierten Strukturdokumenten, beispielsweise im Format EXI (»Efficient XML Interchange«), durch. Diese Bearbeitung umfasst insbesondere ein durchsuchen, filtern, manipulieren, transformieren und abfragen von Daten der in binärkodierten Strukturdokumenten enthaltenen Daten. Beispiele hierfür sind Bearbeitungsprozesse - auf welche in der Fachweilt oftmals auch als »EXI-Prozessoren« Bezug genommen wird - auf Basis der Abfrage- oder Transformationssprachen XPath, XQuery, XSLT, usw.

Aufgrund der im Folgenden genauer erläuterten erfindungsgemäßen Möglichkeit einer Bearbeitung des binärkodierten Strukturdokuments BCS in Zusammenwirkung mit dem binärkodierten Indexdokument BCI gestattet die Erfindung in vorteilhafter Weise einen Einsatz der Transformationssprache XQuery statt der beschränkten Abfragesprache XPath. Die Möglichkeiten der Transformationssprache XQuery gehen über eine reine Abfrage hinaus. Es handelt sich um eine turing-vollständige Sprache mit extensiven Transformationsmöglichkeiten, die weit über die Anfrage- und Filtermöglichkeiten von XPath hinausgehen. Die Abfragesprache XPath bietet demgegenüber nur einen Teilumfang bzw. Subset der Möglichkeiten von XQuery.

Die folgende Figurenbeschreibung erfolgt unter weiterer Bezugnahme auf die Funktionseinheiten der Figur 1. Identische Bezugszeichen in verschiedenen Figuren repräsentieren hierbei identische Funktionseinheiten.

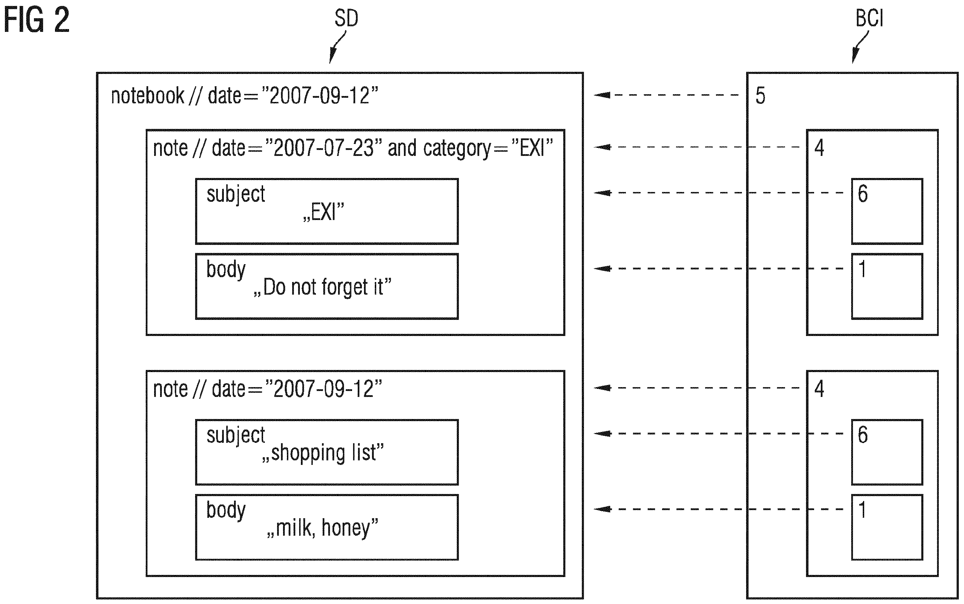

Fig. 2 zeigt eine schematische Darstellung einer Struktur des Indexdokuments BCI in Vergleich mit einem zugrundeliegenden in einer textbasierten Beschreibungssprache, hier XML, aufgebauten Strukturdokument SD.

Dem in der linken Bildhälfte in Strukturblöcken dargestellten beispielhaften Strukturdokument SD liegt folgender XML Code zugrunde:

```
 <?xml version="1.0" encoding="UTF-8"?>
 <notebook date="2007-09-12">
    <note date="2007-07-23" category="EXI">
        <subject>EXI</subject>
        <body>Do not forget it!</body>
    </note>
    <note date="2007-09-12">
        <subject>shopping list</subject>
        <body>milk, honey</body>
    </note>
    </notebook>
```

Es handelt sich dabei um eine XML-Darstellung eines Notizblockes, welcher zwei Notizen enthält. Die Notizen wie der Notizblock selbst sind mit einem jeweiligen Datum in einem ISO 6601-Format der Form JJJJ-MM-TT (Jahr-Monat-Tag) als Attribut referenziert. Die erste Notiz enthält ein weiteres Attribut, nämlich eine Kategorie »EXI«. Darüber hinaus verfügt jede Notiz über einen Betreff bzw. »Subject« und den eigentlichen Inhalt bzw. »Body«.

In der linken Bildhälfte der Fig. 2 ist das den oben gezeigten XML-Code enthaltende Strukturdokument SD in einzelnen Strukturblöcken dargestellt. In der rechten Bildhälfte ist eine schematische Darstellung eines aus dem Strukturdokument SD gebildeten binärkodierten Indexdokuments BCI dargestellt, dem erfindungsgemäß ein struktureller Teilumfang des Strukturdokuments SD zugrunde liegt. In der Zeichnung ist erkennbar, dass den Strukturblöcken des Strukturdokuments SD jeweilige Strukturblöcke des binärkodierten Indexdokuments BCI entsprechen, wie durch gestrichelte Referenzpfeile angedeutet.

Gemäß den üblichen EXI-Kodierungsmaßnahmen sind im binärkodierten Indexdokument BCI kompakte Identifikationsnummern bzw. »Identifier« vorgesehen, welche eine im Strukturdokument SD enthaltene Zeichenkette bzw. »String« ersetzen. Tritt eine Zeichenkette zum wiederholten Male im Strukturdokument SD auf, so wird in der EXI-Kodierung auf diese Zeichenkette als qualifizierter Name bzw. »qname« durch den entsprechenden Identifier referenziert. Hierzu ist eine Pflege von - nicht dargestellten - Ressourcentabellen bzw. »EXI String Tables« vorgesehen. Im vorliegenden Beispiel steht der Identifier 5 im binärkodierten Indexdokuments BCI für den qualifizierten Namen »notebook«, der Identifier 4 für »note«, der Identifier 6 für »subject« und der Identifier 1 für den qualifizierten Namen »body«.

Dem binärkodierten Indexdokument BCI liegt ein Teilumfang des gezeigten XML-Strukturdokuments zugrunde, welcher sich gemäß der hier gezeigten Ausführungsform der Erfindung auf den strukturellen Index beschränkt, nicht aber die eigentlichen Werte, also z.B. den Inhalt »shopping list« des Betreffs »subject« enthält. Das binärkodierte Indexdokument BCI enthält also eine Binärrepräsentation der knappen hierarchischen Datenstruktur der in den Strukturblöcken definierten Elemente, ohne die zughörigen Inhalte.

Der erfindungsgemäße strukturelle Teilumfang des Strukturdokuments BCI umfasst in alternativen Ausführungsformen neben der knappen hierarchischen Datenstruktur bei Bedarf auch Inhalte, welche z.B. häufig bei Anfragen benötigt werden.

Die zeichnerische Darstellung in Strukturblöcken könnte ohne weiteres auch in einer Baumstruktur erfolgen, ohne dass dies Auswirkungen auf die Struktur des binärkodierten Indexdokument BCI selbst hätte.

Eine Anfrage - welche einen Spezialfall einer Bearbeitungsoperation bildet - kann in überwiegenden Fällen bereits mit dem binärkodierten Indexdokument BCI selbst beantwortet werden. Zu solchen Anfragen zählen insbesondere Anfragen an einen Hierarchiezusammenhang, an eine Anzahl oder an bestimmte Kategorien von zu bestimmenden Elementen. Auch weitere Bearbeitungsoperationen, also Modifikationen oder Transformationen struktureller Daten, können in überwiegenden Fällen ausschließlich in Zusammenwirkung mit dem binärkodierten Indexdokument BCI durchgeführt werden. Geht eine solche Bearbeitungsoperation mit einer Modifikation in der Struktur des binärkodierten Indexdokuments BCI einher, so wird die Modifikation durch die Objektschnittstelle OI auch im binärkodierten Strukturdokument BCS durchgeführt. Auf diese Weise wird eine Konsistenz des binärkodierten Indexdokuments BCI - als strukturelles Abbild des binärkodierten Strukturdokuments BCS - mit dem binärkodierten Strukturdokument BCS gewährleistet. Zur Durchführung der Modifikation durch die Objektschnittstelle OI im binärkodierten Strukturdokument BCS werden Fragmente des binärkodierten Strukturdokuments BCS seitens der Objektschnittstelle OI in den Arbeitsspeicher geladen. Der Zugriff auf Werte im binärkodierten Strukturdokument BCS erfolgt über die aus dem binärkodierten Indexdokument BCI bereits bekannte Identifikationsnummer. Diese Maßnahme gestattet einen raschen und wahlfreien Zugriff auf die zu modifizierenden Werte.

Die Objektschnittstelle OI ist insbesondere gemäß dem »Document Object Model« bzw. DOM gestaltet, welche einen Datenzugriff beispielsweise in Form einer Programmierschnittstelle bzw. API (Application Programming Interface) gestattet.

Die Objektschnittstelle OI ist aus Sicht der Bearbeitungsprozesse XP1,XP2,XP3 so ansprechbar, als würde sie das vollständige binärkodierte Strukturdokument BCS geladen haben. Die Objektschnittstelle OI hält allerdings zunächst lediglich die im binärkodierten Indexdokument BCI bereitgestellten Strukturinformationen vor und lädt bei Bedarf Teile des binärkodierten Strukturdokuments BCS mit Hilfe der im binärkodierten Indexdokument BCI bereitgestellten Strukturinformationen nach.

Im Folgenden werden zwei exemplarische Bearbeitungsoperationen mit einer Beschreibung der Mitwirkung des binärkodierten Indexdokuments BCI erläutert.

Gegenstand einer ersten Anfrage sei die Frage, über wie viele Notizen das Notizbuch verfügt. Eine derartige Anfrage wird beispielsweise von einem der Bearbeitungsprozesse XP1,XP2,XP3 auf Basis der Abfragesprachen XPath oder XQuery gestellt, etwa in der Anfragesyntax: »count(/notebook/note/)«. Diese Anfrage kann unter ausschließlicher Beteiligung des binärkodierten Indexdokuments BCI beantwortet werden, indem alle dortigen Elemente mit der Identifikationsnummer 4 - welche die Zeichenkette »note« repräsentiert - gezählt werden.

Gegenstand einer zweiten Anfrage sei die Frage, wie viele Notizen mit der Kategorie »EXI« beaufschlagt sind. Eine derartige Anfrage wird z.B. in folgender Anfragesyntax gestellt: »count(/notebook/note[@category='EXI'])«. Diese Anfrage würde »count(/notebook/note[@category='EXI'])«. Diese Anfrage würde den beiden Identifikationsnummern von ID 4 folgen und diese auflösen, um überprüfen zu können, ob das Attribut »category« vorhanden ist und dieses über den Wert »EXI« verfügt. Die Auflösung erfolgt unter Beteiligung der - nicht dargestellten - Ressourcentabelle bzw. »EXI String Table«. Zur Überprüfung, ob eines der Attribute »category« über den Wert »EXI« verfügt, ist im Unterschied zur obigen Anfrage jedoch das binärkodierte Strukturdokument BCS heranzuziehen, da die Inhalte der Attribute nicht im strukturellen Teilumfang des binärkodierten Indexdokument BCI enthalten sind. Seitens der Objektschnittstelle OI wird daher das entsprechende Fragment des binärkodierten Strukturdokuments BCS geladen und die Überprüfung durchgeführt.

Das binärkodierte Strukturdokument BCS als eigentlicher vollständiger Informationsträger Dokument wird mittels des binären EXI-Formats einerseits kompakt dargestellt und verfügt über Index-Sprungmarken, welche einen wahlfreien Zugriff auf jedes Element ermöglichen. Zur Realisierung eines wahlfreien Zugriffs wird z.B. die in den EXI-Spezifikationen vorgesehene »selfContained«-Eigenschaft von Elementen genutzt.

Weiterhin führt eine Verwendung der bekannten Ersetzung von Elementnamen durch eine entsprechende Identifikationsnummer auch im binärkodierten Indexdokument BCI dazu, dass das binärkodierte Indexdokument BCI im Vergleich zu dessen zugrundeliegenden Strukturdokument SD sehr schlank gehalten ist. Die erfindungsgemäße Beschränkung auf einen strukturellen Teilumfang unter weitgehender Auslassung von Werten führt zu einer noch größeren Verschlankung dieses XIndex, welcher mit den erfindungsgemäßen Maßnahmen komplett in einem Arbeitsspeicher hinterlegt werden kann.

Um diesen wahlfreien Zugriff auf selfContained Elemente des binärkodierten Strukturdokuments BCS zu erzielen, muss lediglich das relevante Element - welches in diesem Zusammenhang als das bedarfsweise benötigte Fragment zu verstehen ist - des binärkodierten Strukturdokuments BCS zur Bearbeitung durch die Objektschnittstelle OI geladen werden, also in vorteilhafter Weise nicht das komplette Strukturdokument BCS bzw. ein umfangreicherer Teil des Strukturdokuments BCS einschließlich etwaiger dem relevanten Element vor- und nachgelagerter Dokumentinhalte.

Gemäß einer Ausführungsform der Erfindung ist vorgesehen, dass das binärkodierte Indexdokument neben dem strukturellen Index auch weitere, insbesondere häufig benötigte Inhalte und Werte enthält. Eine Bearbeitung dieser häufig benötigten Inhalte und Werte erfordert somit kein wiederholtes Laden entsprechender Fragmente des binärkodierten Strukturdokuments BCS seitens der Objektschnittstelle OI. Stattdessen kann eine Bearbeitung dieser häufig benötigten Inhalte und Werte unter ausschließlicher Beteiligung des binärkodierten Indexdokuments BCI erfolgen.

Gemäß einer Ausführungsform der Erfindung ist vorgesehen, einen Inline-Eintrag »<inline/>« in dem binärkodierten Indexdokument BCI zugrundeliegenden Strukturdokument SD vorzusehen, welcher anzeigt, dass ein so gekennzeichnetes Element keine Referenz sondern eine Kopie des Wertes aus dem binärkodierten Strukturdokument BCS enthält.

Ein mit einem Inline-Eintrag »<inline/>« gekennzeichnetes Element in dem daraus erzeugten binärkodierten Indexdokument BCI zugrundeliegenden Strukturdokument SD führt dazu, dass das so gekennzeichnete Element - genauer: eine Binärrepräsentation des gekennzeichneten Elements - in das binärkodierte Indexdokument BCI aufgenommen wird und somit unmittelbar für Bearbeitungsoperationen zugreifbar ist, ohne dass das Fragment seitens der Objektschnittstelle OI aus dem binärkodierten Strukturdokument BCS in den Arbeitsspeicher geladen werden muss.

Inline-Einträge erweisen sich als vorteilhaft, um die Anfragebearbeitung zu beschleunigen, allerdings auf Kosten der Größe des binärkodierten Indexdokuments BCI. Viele Anfragen benötigen zur Auswertung auch bestimmte Werte, z.B. zur Auswertung von Filterprädikaten. Sind diese Werte in Inline-Elementen des binärkodierten Indexdokuments BCI präsent, muss über den Index hinaus kein Zugriff auf das binärkodierte Strukturdokument BCS erfolgen. Das kann für Werte hilfreich sein, die häufig in Anfrageselektionsprädikaten referenziert werden.

Gemäß einer weiteren Ausführungsform der Erfindung ist vorgesehen, einen Ghost-Eintrag »<ghost/>« in dem binärkodierten Indexdokument BCI zugrundeliegenden Strukturdokument SD vorzusehen, der lediglich die Existenz eines Elementes anzeigt, welches darüber hinaus aber keine weiteren Informationen, insbesondere keine Inhalte und/oder Werte enthält. Der Inhalt selbst kann bei Bedarf über eine Referenz auf das binärkodierte Strukturdokument BCS oder auch auf ein anderes - nicht dargestelltes - binärkodiertes Indexdokument eingelesen werden.

Ein mit einem Ghost-Eintrag »<ghost/>« gekennzeichnetes Element in dem daraus erzeugten binärkodierten Indexdokument BCI zugrundeliegenden Strukturdokument SD führt dazu, dass das so gekennzeichnete Element nicht in das binärkodierten Indexdokument BCI aufgenommen wird, sondern lediglich ein Ghost-Eintrag für dieses Element. Der im binärkodierten Indexdokument BCI für dieses Element eingetragene Ghost-Eintrag kennzeichnet lediglich die Existenz dieses Element, nicht aber das Element bzw. dessen Inhalte selbst. Sollte dieses Element von einer Bearbeitungsoperation benötigt werden, muss dieses bei Bedarf seitens der Objektschnittstelle OI aus dem binärkodierten Strukturdokument BCS in den Arbeitsspeicher geladen werden.

Mit einem Ghost-Eintrag versehene Element ermöglichen ein schlank gehaltenes binärkodiertes Indexdokument BCI, selbst bei einem großen zugrundeliegenden Strukturdokument SD. Diese Maßnahme gestattet eine Partitionierung eines bzw. mehrerer binärkodierter Indexdokumente und Auslagerung solcher Teile des Index aus dem Hauptspeicher, welche voraussichtlich selten benötigt werden.

Im Folgenden wird erneut auf die obige XML-Darstellung des Notizblockes Bezug genommen. Eine EXI-Repräsentation des binärkodierten Indexdokuments BCI weist die folgende Struktur auf:

```
 <?xml version="1.0" encoding="UTF-8"?>
 <x:element xmlns:xsi="http://www.w3.org/2001/XMLSchema-instance"
     xsi:schemalocation="http://www.siemens.com/XIndex xindex.xsd
     xmlns:x="http://www.siemens.com/XIndex">
     <notebook/>
     <x:offsetFirstChild>4</x:offsetFirstChild>
     <x:element>
          <note/>
          <x:offsetFirstChild>8</x:offsetFirstChild>
          <x:element>
               <subject/>
               <x:offsetNextSiblinq>6</x:offsetNextSiblinq>
          </x:element>
          <x:element>
               <body/>
               <x:offsetNextParentSibling>21</x:offsetNextParentSibling>
          </x:element>
     </x:element>
     <x:element>
          <note/>
          <x:offsetFirstChild>4</x:offsetFirstChild>
          <x:element>
               <subject>
               <x:offsetNextSiblinq>16</x:offsetNextSiblinq>
          </x:element>
          <x:element>
               <body/>
               <x:offsetNextParentSibling>15</x:offsetNextParentSibling>
          </x:element>
     </x:element>
     </x:element>
```

Das binärkodierte Indexdokument BCI verfügt als Sprungmarke in das eigentliche binärkodierte Strukturdokument BCS vorzugsweise über einen »lokalen« Offset zum jeweils nächsten Element. Auf Grund des unterschiedlichen Typs des nächsten Elementes wird in der oben gezeigten EXI-Repräsentation des binärkodierten Indexdokuments BCI zum besseren Verständnis namentlich zwischen <offsetNextSibling/>, <offsetNextParentSibling/> und <offsetFirstChild/> unterschieden.

Es gibt für jedes Element jeweils genau einen der genannten Offsets und technisch ist die namentliche Unterscheidung der verschiedenen Typen nicht erforderlich. Alternativ wird der Offset daher auch generisch bezeichnet, z.B. als

```
<offsetNextElementInDocumentOrder/>.
```

Ein absoluter Offset im Gegensatz zum oben beschriebenen lokalen Offset hätte demgegenüber den Vorteil, dass die Anzahl der im binärkodierten Strukturdokument BCS zu überspringenden Bytes, um das vollständige relevante Element einlesen zu können, in einem Schritt zu ermitteln wäre. Im Fall von strukturellen oder inhaltlichen Modifikationen der im binärkodierten Strukturdokument BCS enthaltenen Daten müssten bei einem absoluten Offset jedoch eventuell alle nachfolgenden Elementindices aktualisiert werden. Bei Verwendung eines lokalen Offsets ziehen solche Modifikationen eines Elementes hingegeben lediglich eine Aktualisierung in der darüber liegenden Hierarchie nach sich.

Lokale Offsets werden in vorteilhafter Weise verwendet, um bei einer Anfrage seitens eines der Bearbeitungsprozesse XP1,XP2,XP3 einen nicht relevante Teil überspringen zu können. Beispielsweise würde eine Anfrage nach
/notebook/note/body
dazu führen, dass das Element <subject> vor body als nicht relevant erachtet und durch den Offset übersprungen werden kann.

Ein weiteres Beispiel wäre eine Anfrage gemäß
/notebook/editor,
welche ein Element »editor« sucht, das tatsächlich nicht existiert. Sobald die Anfrage auf ein <notebook> Element stößt, wird dieses direkt übersprungen, weil darin kein <editor> Element enthalten und daher irrelevant ist.

Die Länge eines zu überspringenden Elements errechnet sich gemäß der folgenden Vorschrift:
1. Initialisiere Länge mit 0
2. Addiere Länge mit <offsetFirstChild> wenn vorhanden und springe zu firstChild index ODER wenn nicht vorhanden Addiere entweder <offsetNextSibling> ODER <offsetNextParentSibling> (eines ist vorhanden) und springe zum besagten Index
3. Solange Schritt 2. fortführen bis
   a. wenn Element Kinder hat (hat mit <offsetFirstChild> begonnen) bis jedes Kind mit <offsetNextParentSibling> abgeschlossen wurde;
   b. wenn Element keine Kinder hat dann beinhaltet <offsetNextSibling> die Länge.

In der folgenden Tabelle sind die Offsets zusammengestellt.

| AO | | | | | L | OFC | ONS | ONP |
|---|---|---|---|---|---|---|---|---|
| 0 | EXI Header | | | | | | | |
| 1 | SE(notebook) | | | | 74 | 4 | | |
| | AT(date="2007-09-12") | | | | | | | |
| 5 | | | | SE(note) | 35 | 8 | | |
| | | AT(category="EXI") | | | | | | |
| | | AT(date="2007-07-23") | | | | | | |
| 13 | | | SE(subject) | | 6 | | 6 | |
| | | | CH("EXI") | | | | | |
| | | | EE(subject) | | | | | |
| 19 | | | SE(body) | | 21 | | | 21 |
| | | | CH("Do not forget it!") | | | | | |
| | | | EE(body) | | | | | |
| | | EE(note) | | | | | | |
| 40 | | SE(note) | | | 35 | 4 | | |
| | | AT(date="2007-09-12") | | | | | | |
| 44 | | | SE(subject) | | 16 | | 16 | |
| | | | CH("shopping list") | | | | | |
| | | | EE(subject) | | | | | |
| 60 | | | SE(body) | | | | | 15 |
| | | | CH("milk, honey") | | | | | |
| | | | EE(body) | | | | | |
| | | EE(note) | | | | | | |
| 75 | EE (notebook) | | | | | | | |
| | | | | | | | | |

Darin bedeutet in den Spaltenköpfen:
- AO:: Absoluter Offset (Absoulute Offset)
- L:: Länge (Length) in Bytes
- OFC:: Offset zum ersten Kind (offsetFirstChild)
- ONS:: Offset zum nächsten Geschwisterkind (offsetNextSibling)
- ONP:: Offset zum nächsten Elternteil (offsetNextParentSibling)

In der Tabelle wird ein Start-Tag eines EXI-Elements mit Start Element bzw. SE, das korrespondierende Ereignis oder Event auf den End Tag als End Element bzw. EE, bezeichnet. Die Attribute eines Start-Tags sind mit AT eingetragen. Das Event, auf das die Daten eines Elementes folgen, wird mit Character bzw. CH bezeichnet.

Eine Berechnung der Länge für notebook[1] ergibt 74, also 4 + 8 + 6 + 21 + 4 + 16 + 15

Eine Berechnung der Länge für note[1] ergibt 35, also 8 + 6 + 21

Eine Berechnung der Länge für note[2] ergibt 35: 4 + 16 + 15 Eine Berechnung der Länge für note[2]/subject[1] ergibt 16: 16

Die erfindungsgemäße Durchführung von Bearbeitungsoperationen am binärkodierten Indexdokuments BCI, welcher auch als XIndex bezeichnet wird, weist folgende Vorteile auf:
- Das Verfahren ermöglicht schnellere Anfragebearbeitung, indem bestimmte Anfragen bereits mittels des Indexdokuments BCI bearbeitet werden können;
- Erheblich reduzierter Hauptspeicherverbrauch während der Verarbeitung von Anfragen, sowohl auf ressourcenlimitierten Geräten als auch auf anderen Rechnersystemen, bis hin zu Servern;
- Das Verfahren ermöglicht neben einer Anfrage auch eine Modifikation der im Indexdokument BCI enthaltenen Daten, welche aus dem zugrunde liegenden in einer textbasierten Beschreibungssprache aufgebauten Strukturdokument SD stammen;
- Das Verfahren liefert als Resultat die bereits vorliegenden Daten in effizienter Form, also mittels des Formats EXI;
- Das Verfahren ermöglicht den Einsatz von Standardtechnologien wie z.B. der Transformationssprache XQuery auch auf ressourcenlimitierten Geräten wie Embedded Systems, welche im Gegensatz zur Anfragesprache XPath eine Transformation von Daten über ein reines Abfragen oder Filtern gestattet.

## Patentansprüche

1. Verfahren zur Bearbeitung eines binärkodierten Strukturdokuments (BCS) in einem Gerät,
wobei dem binärkodierten Strukturdokument (BCS) ein in einer textbasierten Beschreibungssprache aufgebautes Strukturdokument (SD) zugrunde liegt und wobei einem binärkodierten Indexdokument (BCI) ein struktureller Teilumfang des Strukturdokuments (SD) zugrunde liegt;
umfassend die Schritte:
- Hinterlegung einer Speicherrepräsentation des binärkodierten Indexdokuments (BCI) in einem Arbeitsspeicher des Geräts, wobei die Struktur des binärkodierten Indexdokuments (BCI) mit der Struktur des binärkodierten Strukturdokuments (BCS) identisch ist;
- Hinterlegung des binärkodierten Strukturdokuments (BCS) in einem dem Gerät zugeordneten Hintergrundspeicher;
- Durchführung von Bearbeitungsoperationen durch mindestens einen Bearbeitungsprozess (XP1,XP2,XP3) mit Zugriff auf die Speicherrepräsentation des binärkodierten Indexdokuments (BCI) über eine Objektschnittstelle (OI), wobei bedarfsweise Fragmente des binärkodierten Strukturdokuments (BCS) seitens der Objektschnittstelle (OI) in den Arbeitsspeicher geladen werden.

2. Verfahren nach Patentanspruch 1, **dadurch gekennzeichnet, dass** das binärkodierte Indexdokument (BCI) und/oder das binärkodierte Strukturdokument (BCS) in einem Efficient-XML-Interchange-Format bzw. EXI-Format vorliegen.

3. Verfahren nach einem der vorgenannten Patentansprüche, **dadurch gekennzeichnet, dass** die textbasierte Beschreibungssprache eine Extensible Markup Language bzw. XML ist.

4. Verfahren nach einem der vorgenannten Patentansprüche, **dadurch gekennzeichnet, dass** im binärkodierten Indexdokument (BCI) Elemente aufgrund einer Kennzeichnung eines entsprechenden Elements im zugrundeliegenden Strukturdokument (SD) unmittelbar für Bearbeitungsoperationen zugreifbar im binärkodierten Indexdokument (BCI) enthalten sind.

5. Verfahren nach einem der vorgenannten Patentansprüche 1 bis 3, **dadurch gekennzeichnet, dass** im binärkodierten Indexdokument (BCI) Elemente aufgrund einer Kennzeichnung eines entsprechenden Elements im zugrundeliegenden Strukturdokument (SD) im binärkodierten Indexdokument (BCI) ausgeschlossen sind und dass die Elemente bei Bedarf seitens der Objektschnittstelle (OI) aus dem binärkodierten Strukturdokument (BCS) entnommen und in den Arbeitsspeicher geladen werden.

6. Computerprogrammprodukt mit Mitteln zur Durchführung des Verfahrens nach einem der vorhergehenden Patentansprüche, wenn das Computerprogrammprodukt an einem Gerät zur Ausführung gebracht wird.

7. Gerät zur Bearbeitung eines binärkodierten Strukturdokuments (BCS), umfassend,
- ein dem Gerät zugeordneter Hintergrundspeicher zur Hinterlegung des binärkodierten Strukturdokuments (BCS), dem binärkodierten Strukturdokument (BCS) zugrundliegend ein in einer textbasierten Beschreibungssprache aufgebautes Strukturdokument (SD);
- mit einem Arbeitsspeicher zur Hinterlegung eines binärkodierten Indexdokuments (BCI) auf Grundlage eines strukturellen Teilumfangs des Strukturdokuments (SD), wobei die Struktur des binärkodierten Indexdokuments (BCI) mit der Struktur des binärkodierten Strukturdokuments (BCS) identisch ist;
- mit einer Objektschnittstelle (OI) für einen Zugriff auf das binärkodierte Indexdokument (BCI) bei einer Durchführung von Bearbeitungsoperationen durch mindestens einen Bearbeitungsprozess, die Objektschnittstelle (OI) eingerichtet für ein bedarfsweise Laden von Fragmenten des binärkodierten Strukturdokuments (BCS) in den Arbeitsspeicher.

## Claims

1. Method for processing a binary-coded structure document (BCS) in a device,
wherein the binary-coded structure document (BCS) is based on a structure document (SD) compiled in a text-based description language, and wherein a binary-coded index document (BCI) is based on a structural subset of the structure document (SD); comprising the steps:
- storing a storage representation of the binary-coded index document (BCI) in a working memory of the device, wherein the structure of the binary-coded index document (BCI) is identical to the structure of the binary-coded structure document (BCS);
- storing the binary-coded structure document (BCS) in a background storage unit assigned to the device;
- carrying out processing operations by means of at least one processing process (XP1, XP2, XP3) by accessing the storage representation of the binary-coded index document (BCI) via an object interface (OI), wherein fragments of the binary-coded structure document (BCS) are loaded into the working memory by the object interface (OI) as required.

2. Method according to Claim 1, **characterized in that** the binary-coded index document (BCI) and/or the binary-coded structure document (BCS) exist in an Efficient-XML-Interchange format or EXI format.

3. Method according to any one of the preceding claims, **characterized in that** the text-based description language is an extensible markup language, or XML.

4. Method according to any one of the preceding claims, **characterized in that**, in the binary-coded index document (BCI), elements are included which are directly accessible for processing operations in the binary-coded index document (BCI) based on an identifier of a corresponding element in the underlying structure document (SD).

5. Method according to any one of the preceding Claims 1 to 3, **characterized in that**, in the binary-coded index document (BCI), elements are excluded in binary-coded index document (BCI) based on an identifier of a corresponding element in the underlying structure document (SD), and **in that** the elements are extracted from the binary-coded structure document (BCS) by the object interface (OI) as required and loaded into the working memory.

6. Computer program product having means for carrying out the method according to any one of the preceding claims, when the computer program product is executed on a device.

7. Device for processing a binary-coded structure document (BCS), comprising
- a background storage unit assigned to the device for storing the binary-coded structure document (BCS), the binary-coded structure document (BCS) being based on a structure document (SD) compiled in a text-based description language;
- with a working memory for storing a binary-coded index document (BCI) based on a structural subset of the structure document (SD), wherein the structure of the binary-coded index document (BCI) is identical to the structure of the binary-coded structure document (BCS);
- with an object interface (OI) for access to the binary-coded index document (BCI) during execution of processing operations by at least one processing process, the object interface (OI) being configured for loading fragments of the binary-coded structure document (BCS) into the working memory as required.

## Revendications

1. Procédé de traitement d'un document de structure codé en binaire (BCS) dans un appareil, dans lequel le document de structure codé en binaire (BCS) est basé sur un document de structure (SD) construit dans un langage de description basé sur du texte et dans lequel un document d'indexation codé en binaire (BCI) est basé sur un périmètre partiel structurel du document de structure (SD); comprend les étapes consistant à :
- déposer une représentation en mémoire du document d'indexation codé en binaire (BCI) dans une mémoire de travail du dispositif, la structure du document d'indexation codé en binaire (BCI) étant identique à la structure du document de structure codé en binaire (BCS) ;
- déposer le document de structure codé en binaire (BCS) dans une mémoire d'arrière-plan associée à l'appareil ;
- exécuter des opérations de traitement par au moins un processus de traitement (XP1, XP2, XP3) avec accès à la représentation en mémoire du document d'indexation codé en binaire (BCI) par l'intermédiaire d'une interface objet (OI), des fragments du document de structure codé en binaire (BCS) étant chargés en cas de besoin dans la mémoire de travail du côté de l'interface objet (OI).

2. Procédé selon la revendication 1, **caractérisé en ce que** le document d'indexation codé en binaire (BCI) et/ou le document de structure codé en binaire (BCS) se présentent sous un format d'échange Efficient-XML, respectivementsous un format EXI.

3. Procédé selon l'une des revendications précitées, **caractérisé en ce que** le langage de description basé sur du texte est un Extensible Markup Language, respectivementXML.

4. Procédé selon l'une des revendications précitées, **caractérisé en ce que** des éléments sont contenus dans le document d'indexation codé en binaire (BCI) sur la base d'un marquage d'un élément correspondant dans le document de structure (SD) sous-jacent, de manière à être directement accessibles pour des opérations de traitement dans le document d'indexation codé en binaire (BCI).

5. Procédé selon l'une des revendications 1 à 3 précitées, **caractérisé en ce que**, dans le document d'indexation codé en binaire (BCI), des éléments sont exclus du document d'indexation codé en binaire (BCI) en raison d'une caractérisation d'un élément correspondant dans le document de structure (SD) sous-jacent et **en ce que** les éléments sont prélevés en cas de besoin du côté de l'interface objet (OI) dans le document de structure codé en binaire (BCS) et chargés dans la mémoire de travail.

6. Produit de programme informatique comprenant des moyens pour mettre en œuvre le procédé selon l'une des revendications précédentes, lorsque le produit de programme informatique est mis en œuvre sur un appareil.

7. Appareil de traitement d'un document de structure codé en binaire (BCS), comprenant,
- une mémoire d'arrière-plan associée à l'appareil pour le dépôt du document de structure codé en binaire (BCS), à la base du document de structure codé en binaire (BCS) se trouve un document de structure (SD) construit dans un langage de description basé sur du texte ;
- avec une mémoire de travail pour le dépôt d'un document d'indexation codé en binaire (BCI) sur la base d'un périmètre partiel structurel du document de structure (SD), la structure du document d'indexation codé en binaire (BCI) étant identique à la structure du document de structure codé en binaire (BCS) ;
- avec une interface objet (OI) pour un accès au document d'indexation codé en binaire (BCI) lors d'une exécution d'opérations de traitement par au moins un processus de traitement, l'interface objet (OI) étant conçue pour un chargement en cas de besoin de fragments du document de structure codé en binaire (BCS) dans la mémoire de travail.
